# EUROPEAN PATENT APPLICATION

(11) **EP 1 980 646 A1**
(43) Date of publication of application: **15.10.2008**
(21) Application number: 08152696.4
(22) Date of filing: 13.03.2008
(51) Int. Cl.: C23C 16/04, H01L 21/762

(54) **Improved gap-fill despositions in the formation of silicon containing dielectric materials**

(30) Priority: 15.03.2007 US 686863
(71) Applicant: Applied Materials, Inc., Santa Clara, CA 95054 (US)
(72) Inventor: Ingle, Nitin K., Santa Clara CA California 95051 (US); Bhatia, Sidharth, Sunnyvale CA California 94086 (US); Bang, Won B., Santa Clara CA California 95050 (US); Yuan, Zheng, Cupertino CA California 95014 (US); Yieh, Ellie, San Jose 95138 (US); Venkatraman, Shankar, 95051 CA California Santa Clara (US)
(74) Representative: Zimmermann & Partner

(57) **Abstract**

A chemical vapor deposition method for forming a dielectric material in a trench formed on a substrate, where the method includes the steps of generating water vapor by contacting hydrogen gas and oxygen gas with a water vapor generation catalyst, and providing the water vapor to the process chamber. The method also includes flowing a silicon-containing precursor into the process chamber housing the substrate, flowing an oxidizing gas into the chamber, and causing a reaction between the silicon-containing precursor, the oxidizing gas and the water vapor to form the dielectric material in the trench. The method may also include increasing over time a ratio of the silicon-containing precursor to the oxidizing gas flowed into the chamber to alter a rate of deposition of the dielectric material.

## Description

### BACKGROUND OF THE INVENTION

The fabrication sequence of integrated circuits often includes several patterning processes. The patterning processes may define a layer of conductors, such as a patterned metal or polysilicon layer, or may define isolation structures, such as trenches. In many cases the trenches are filled with an insulating, or dielectric, material. This insulating material can serve several functions. For example, in some applications the material serves to both electrically isolate one region of the IC from another, and electrically passivate the surface of the trench. The material also typically provides a base for the next layer of the semiconductor to be built upon.

After patterning a substrate, the patterned material is not flat. The topology of the pattern can interfere with or degrade subsequent wafer processing. It is often desirable to create a flat surface over the patterned material. Several methods have been developed to create such a flat, or "planarized", surface. Examples include depositing a conformal layer of material of sufficient thickness and polishing the wafer to obtain a flat surface, depositing a conformal layer of material of sufficient thickness and etching the layer back to form a planarized surface, and forming a layer of relatively low-melting point material, such as doped silicon oxide, and then heating the wafer sufficiently to cause the doped silicon oxide to melt and flow as a liquid, resulting in a flat surface upon cooling. Each process has attributes that make that process desirable for a specific application.

As semiconductor design has advanced, the feature size of the semiconductor devices has dramatically decreased. Many circuits now have features, such as traces or trenches less than a micron across. While the reduction in feature size has allowed higher device density, more chips per wafer, more complex circuits, lower operating power consumption and lower cost among other benefits, the smaller geometries have also given rise to new problems, or have resurrected problems that were once solved for larger geometries.

An example of the type of manufacturing challenge presented by sub-micron devices is the ability to completely fill a narrow trench in a void-free manner. To fill a trench with silicon oxide, a layer of silicon oxide is first deposited on the patterned substrate. The silicon oxide layer typically covers the field, as well as walls and bottom of the trench. If the trench is wide and shallow, it is relatively easy to completely fill the trench. As the trench gets narrower and the aspect ratio (the ratio of the trench height to the trench width) increases, it becomes more likely that the opening of the trench will "pinch off".

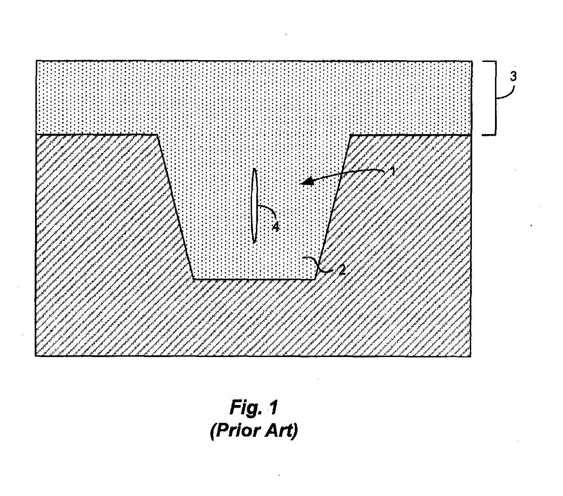

Pinching off a trench may trap a void within the trench. Fig. 1 shows such a void 4 formed in the dielectric material 2 that fills trench 1. These voids commonly occur in gapfill depositions where dielectric materials are rapidly deposited in high aspect ratio trenches. Void 4 creates inhomogeneities in the dielectric strength of the gapfill that can adversely affect the operation of a semiconductor device.

One approach to forming fewer voids is to slow down the dielectric deposition rate. Slower deposition rates facilitate a more conformal deposition of the dielectric material on the trench surfaces, which reduces excess buildup of dielectric materials on the top corners of the trench that can result in pinching off. As a result, trenches are more evenly filled from the bottom up. However, lowering the deposition rate of the dielectric material also reduces process efficiency by increasing the total dielectric deposition time. The slower dielectric deposition rates not only increase the time for filling trench 1, but also the bulk dielectric layer 3 on top of trench 1.

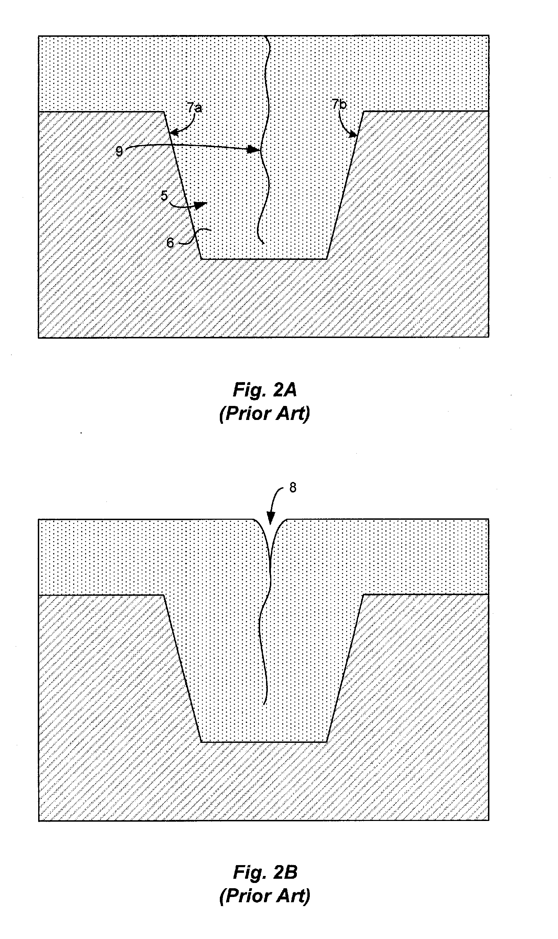

Another challenge encountered in gap-fill processes is the formation of weak seams at the interface of the dielectric material with a trench surface, as well as between surfaces of the dielectric materials itself. Weak seams can form when the deposited dielectric materials adhere weakly, or not at all, to the inside surfaces of a trench. Subsequent process steps (*e.g.*, annealing) can detach the dielectric material from the trench surface and create a fissure in the gap-filled trench. Weak seams can also be formed between dielectric surfaces as illustrated in Fig. 2A, which shows a weak seam 9 in the middle of trench 5 that has been formed at the intersection of opposite faces of silicon oxide material 6 growing outward from opposite sidewalls (7a and 7b) of trench 5.

The dielectric material along seam 9 has a lower density and higher porosity than other portions of the dielectric material 6, which can cause an enhanced rate of etching along the seam 9. Fig. 2B illustrates how unwanted dishing 8 can develop along seam 4 when the dielectric material 6 is exposed to an etchant (*e.g*., HF) during processes such as chemical-mechanical polishing (CMP) and post-CMP cleaning. Like voids, weak seams create inhomogeneities in the dielectric strength of the gapfill that can adversely affect the operation of a semiconductor device.

In some circumstances, voids and weak seams in dielectric trench fills may be filled in or "healed" using a reflow process. For example, some doped silicon oxide dielectric materials experience viscous flow at elevated temperatures, permitting the reduction of voids and weak seams with high-temperature reflow processes. However, as the trench becomes narrower, it becomes more likely that the void will not be filled during these reflow process. In addition, reflow processes are not practical in many applications where high melting point dielectrics, such as undoped silicon oxide, are used for the gapfill. Thus, there remains a need for new systems and methods to reduce or eliminate voids and weak seams in dielectric gapfills.

### BRIEF SUMMARY OF THE INVENTION

Embodiments of the invention include a chemical vapor deposition method for forming a dielectric material in a trench formed on a substrate. The method may include the steps of generating water vapor by contacting hydrogen gas and oxygen gas with a water vapor generation catalyst, and providing the water vapor to the process chamber. The method may also include flowing a silicon-containing precursor into the process chamber housing the substrate, flowing an oxidizing gas into the chamber, and causing a reaction between the silicon-containing precursor, the oxidizing gas and the water vapor to form the dielectric material in the trench. The method may still further include increasing over time a ratio of the silicon-containing precursor to the oxidizing gas flowed into the chamber to alter a rate of deposition of the dielectric material.

Embodiments of the invention also include a chemical vapor deposition method for forming dielectric layers on a substrate. The methods may include the steps of generating water vapor by contacting hydrogen gas and oxygen gas with a water vapor generation catalyst, and providing the water vapor to a chamber housing the substrate. The methods may also include providing a silicon-containing precursor, an oxidizing processing gas, and the water vapor to the chamber, where the silicon-containing precursor, the oxidizing processing gas, and the water vapor react to form a first dielectric layer on the substrate. A ratio of the silicon-containing precursor to the oxidizing processing gas flowed into the chamber may be varied over time to alter a deposition rate of the first dielectric layer. In addition, the flow of the water vapor into the chamber may be discontinued and a second dielectric layer may be formed on the first dielectric layer, where the second dielectric layer is formed without the water vapor.

Embodiments of the invention further include substrate processing apparatuses. The apparatuses may include a substrate support configured to support a substrate within a processing chamber, and a gas delivery system configured to receive a silicon-containing precursor, an oxidizing processing gas, and water vapor and deliver them to the processing chamber. The apparatuses may further include a water vapor generator that provides the water vapor to the gas delivery system. The generator may include a catalyst that produces the water vapor by from a mixture of hydrogen gas and oxygen gas. The apparatuses may still further include a controller configured to control the gas delivery system and the substrate support. The controller may introduce the silicon-containing precursor, the water vapor and the oxidizing processing gas into the processor chamber to form a dielectric layer on the substrate, and alter the position of the substrate support relative to the gas delivery system during the deposition of the dielectric layer.

Additional embodiments and features are set forth in part in the description that follows, and in part will become apparent to those skilled in the art upon examination of the specification or may be learned by the practice of the invention. The features and advantages of the invention may be realized and attained by means of the instrumentalities, combinations, and methods described in the specification.

### BRIEF DESCRIPTION OF THE DRAWINGS

Fig. 1 shows a trench filled with a dielectric material that includes a void;

Fig. 2A shows a trench filled with a dielectric material that includes a weak seam;

Fig. 2B shows the conventional oxide-filled trench of Fig. 2A after a chemical mechanical polishing;

Figs. 3A-B are flowcharts illustrating steps that may be included in processes of forming a dielectric layer on a substrate according to embodiments of the invention;

Figs. 4A-B are simplified graphs plotting the relative concentration of a silicon-containing components over time according to embodiments of the invention;

Figs. 5A-B are a set of comparative electron micrographs of gap-filled trenches;

Figs. 6A-B are another set of comparative electron micrographs of gap-filled trenches;

Fig. 7 is a graph of dielectric film properties versus the flow rate of water vapor during the deposition of the dielectric film;

Figs. 8A-D show the number of particle adders deposited on wafer surfaces following oxide depositions at various water dilution levels;

Figs. 9A-B show the number of particle adders deposited on the surface of a substrate wafer using different water vapor generation methods;

Fig. 10 shows a simplified cross-sectional view of an oxide-filled trench in accordance with an embodiment of the present invention;

Fig. 11 is a simplified cross section of a portion of an integrated circuit according to the present invention;

Fig. 12A is a simplified schematic of a system for depositing a dielectric layer according to embodiments of the invention;

Fig. 12B is a simplified representation of a CVD apparatus according to the present invention;

Fig. 12C is a simplified representation of the user interface for a CVD system in relation to a deposition chamber in a multi-chamber system;

Fig. 12D is a simplified diagram of a gas panel and supply lines in relation to a deposition chamber; and

Fig. 12E shows a schematic view of another gas flow system in accordance with embodiments of the present invention.

### DETAILED DESCRIPTION OF THE INVENTION

As noted above, the development of voids and weak seams in trench isolations has become an increasing problem, particularly as trench widths get smaller (*e.g.*, about 90 nm or less) and trench aspect ratios get higher (*e.g.*, about 6:1 or higher). The present invention includes systems and methods of forming dielectric materials in these trenches using a water vapor to help reduce voids and weak seams in the gapfill. The water vapor enhances the flowability and density of the silicon oxide material, helping to heal weak seams and fill in voids formed during the deposition.

Water vapor may also increases the density of the silicon oxide material formed in the trench. The higher density of the material may provide advantages over less dense material, including giving the material a slower wet etch rate. Less dense materials deposited in the trenches by, for example, conventional, moisture free chemical vapor deposition typically have wet etch rates of about 5:1 or more. The high wet etch rates of the material can result in the overetching during subsequent planarization and/or oxide etching processes. This overetching may result in the formation of bowls or gaps at the tops of the trench isolations.

It has been discovered that the physical (*e.g.*, phase) characteristics of the water vapor can have a significant impact on the quality of the dielectric material formed. When the water vapor provided to the process chamber contains a substantial liquid phase component-like and aerosol spray-a large number of particle adders are observed on the substrate surface in post-deposition inspections. In contrast, when the water vapor provided to the chamber is substantially all in the gas phase, with few or no aerosol particles, the number of particle adders is significantly reduced, sometimes by a factor of ten or more.

Embodiments of the present invention have appreciated this discovery by implementing methods and equipment for providing water vapor to a process chamber that has a reduced number of liquid aerosol phase droplets, and is primarily in the gas phase. These embodiments include generating water vapor catalytically by contacting oxygen and hydrogen precursor gases with a water generation catalyst. The precursors react catalytically in the presence of the catalyst to form the water vapor. Because the catalytic reaction forms water vapor at the molecular level, the water vapor is formed in a substantially pure gas phase as opposed to a liquid or aerosol phase. The catalytically generated water vapor may be provided to a dielectric deposition process chamber in this substantially pure gas phase with few or even no liquid aerosol phase droplets.

In contrast, water vapor from bubblers and nebulizers start with liquid phase water that is converted into a mixture of gas and aerosol particles. In the bubbler, a carrier gas such as nitrogen or helium is bubbled through a sample of liquid water to carry away water vapor from the sample into the process chamber. Because this method starts with liquid water, a substantial amount of liquid aerosol droplets are swept up by the carrier gas and transported into the process chamber. Nebulizers can generate even more liquid aerosol water droplets because they function by aerosolizing liquid water into an aerosol mist that is transported by a carrier gas into the process chamber. For both these water vapor generation methods, the amount of liquid aerosol water vapor generated can be significantly higher than for catalytic water vapor generation.

Another method for generating water vapor involves the combustion of a mixture of hydrogen and oxygen gas inside the process chamber, sometimes called in-situ generated steam (ISSG). The water vapor produced is gas phase, but its also high temperature and needs to be rapidly cooled. The cooling process can promote condensation of the gas phase water molecules into liquid aerosol droplets in the process chamber. Moreover, because the combustion reaction is highly exothermic, the amounts of hydrogen and oxygen gas that can be reacted inside the process chamber has to be kept low to keep the chamber temperature from increasing too much. This can be especially problematic for moderate and low temperature (e.g., about 500°C or less) dielectric depositions that limit the amount (i.e., partial pressure) of water vapor that can be generated by this method.

Embodiments of the invention include using the generated water vapor and other precursors in a high aspect ratio processes (HARPs) to form the dielectric material. These processes include depositing the dielectric material at different rates in different stages of the process. For example, a lower deposition rate may be used to form a more conformal dielectric layer in a trench, while a higher deposition rate is used to form a bulk dielectric layer above the trench. In other examples, multiple rates (*e.g.*, 3 or more rates) are used at various stages of the formation of the dielectric layer. Performing the deposition at a plurality of dielectric deposition rates reduces the number of voids and weak seams in the trenches without significantly reducing the efficiency of the deposition process. Combining the advantages of HARP with catalytically generated water vapor permits the efficient formation of low defect, low-particle adder, high-density, dielectric materials in trenches and bulk dielectric layers.

### Exemplary Oxide Deposition Processes

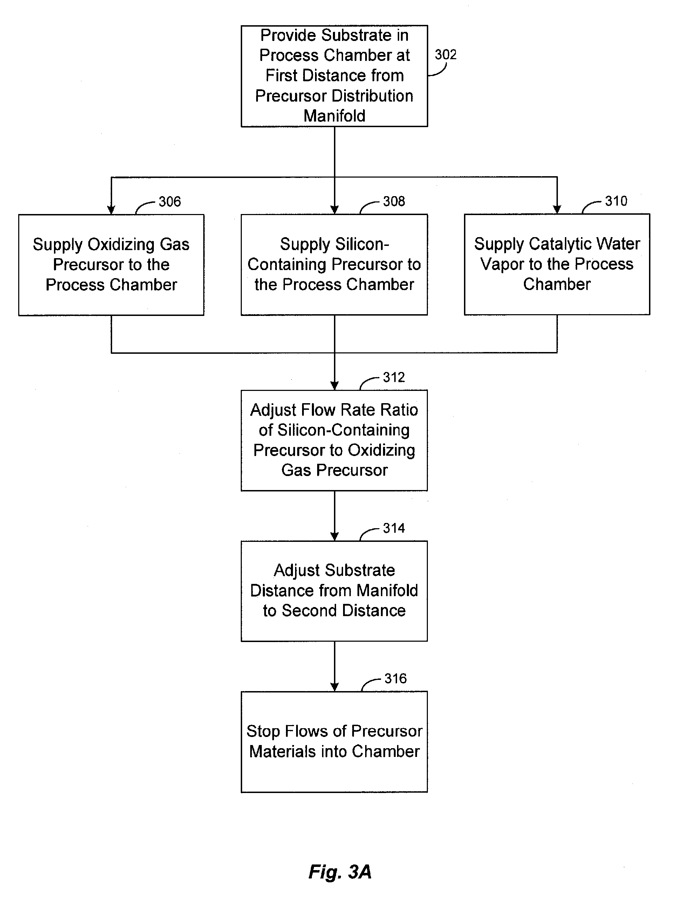

Fig. 3A is a flowchart that illustrates steps that may be included in a process of forming a dielectric layer on a substrate according to embodiments of the invention. These embodiments include using HARP techniques for varying the deposition rate of the dielectric materials during the formation of the dielectric layer. The process includes providing a substrate in a process chamber at a first distance from a gas distribution manifold (*e.g.*, showerhead) in step 302. The gas distribution manifold may include separate inlets for the precursor materials, or a single inlet through which mixtures of the precursors enter the process chamber.

After the substrate is placed in the process chamber, the precursor materials may be supplied to the chamber. This may include supplying an oxidizing gas precursor 306 (*e.g.*, O₂, O₃, NO, NO₂, mixtures thereof, *etc.*), a silicon-containing precursor 308 *(e.g.,* silane, dimethylsilane, trimethylsilane, tetramethylsilane, diethylsilane, tetramethylorthosilicate (TMOS), tetraethylorthosilicate (TEOS), octamethyltetrasiloxane (OMTS), octamethylcyclotetrasiloxane (OMCTS), tetramethylcyclotetrasiloxane (TOMCATS), mixtures thereof, *etc.),* and catalytically generated water vapor 310 to the chamber. The water vapor and other precursors may pass through the manifold and into the chamber. The process may also include the introduction of one or more additional hydroxyl-containing precursors (*e.g.,* H₂O₂, *etc.*) that may be premixed with one or more of the precursors, or separately provided to the process chamber. A reducing gas precursor such as hydrogen gas (H₂) or ammonia (NH₃) may also be introduced to the process chamber.

When the water vapor and other precursors are supplied to the process chamber via the manifold, they may each flow separately into the process chamber, or two or more of them may be premixed in the manifold before being supplied to the process chamber. For example, the water vapor and oxidizing gas precursor may be premixed and supplied to the chamber together. As another example, water vapor and an additional hydroxyl-containing precursor may be supplied to the chamber as a mixture. As still another example, a reducing gas and the silicon-containing precursor may be supplied together as a mixture. In yet more examples, all the precursors may be premixed before being supplied as one mixture to the chamber. In addition, one or more of the precursors may be mixed with a carrier gas (*e.g.*, an inert gas such as a noble gas (He, Ne, Ar, Kr, Xe), nitrogen gas, *etc.)* before being supplied to the chamber.

The precursors may flow through the manifold and into the process chamber at an initial flow rate. For example, the silicon-containing precursor may initially flow through the manifold at about 20 to about 100 sccm, while the oxidizing precursor flows at about 60 to about 1000 sccm, and the water vapor flows at about 60 to about 200 sccm. These flow rates may be substantially higher if the water vapor and other precursors are mixed with one or more carrier gases before being supplied to the chamber. For example, a mixture of the silicon-containing precursor and a carrier gas may flow at rate of about 1000 sccm to about 10,000 sccm (*e.g.*, about 6000 sccm to about 8000 sccm). The oxidizing precursor and a carrier gas may flow at about 1000 sccm to about 20,000 sccm (*e.g.*, about 10,000 sccm to about 20,000 sccm). The water vapor and a carrier gas may flow at about 1000 to about 20,000 sccm (*e.g.*, about 5000 sccm to about 15,000 sccm). If a reducing gas is also provided, it may flow with a carrier gas about 1000 sccm to about 10,000 sccm (*e.g.*, about 5000 sccm).

Depending on the type of CVD process used, the water vapor and/or one or more of the other precursors may first help form a plasma whose products are used to form the dielectric layer on the substrate. Embodiments of the invention may be used with plasma CVD techniques such as plasma enhanced CVD (PECVD), and high density plasma CVD (HDPCVD). Embodiments include *in situ* plasma generation in the process chamber (*e.g.*, between a capacitively coupled showerhead and substrate pedestal/substrate), and/or remote plasma generation using a plasma generator positioned outside the process chamber. Embodiments also include thermal CVD techniques such as atmospheric pressure CVD (APCVD), sub-atmospheric CVD (SACVD), and low-pressure CVD (LPCVD), among others.

The initial flow rates of the precursors establish first flow rate ratios for the silicon-containing precursor:oxidizing gas precursor, and the silicon-containing precursor:water vapor. When the initial deposition of dielectric materials includes trench fills, the ratio of silicon-containing precursor:oxidizing gas precursor may be relatively low to provide a slower deposition of dielectric materials in the trenches. As the deposition progresses, the ratio of silicon-containing precursor:oxidizing gas precursor may be adjusted in step 312. For example, once a portion of the trenches has been filled, the ratio of silicon-containing precursor:oxidizing gas precursor may be increased to increase the deposition rate of the dielectric material. The adjustment is made at a stage of the deposition when there is reduced risk of the higher deposition rate causing voids or weak seams in the trenches.

The flow rate ratio of the silicon-containing precursor to the water vapor may also be relatively low in the initial deposition stage. When the flow rate ratio of silicon-containing precursor:oxidizing gas precursor is increased, the ratio of silicon-containing precursor:water vapor may increase as well. Alternatively, the ratio of silicon-containing precursor:water vapor may remain substantially constant as the ratio of silicon-containing precursor:oxidizing gas varies, such as embodiments where the silicon-containing and water vapor flow together into the process chamber.

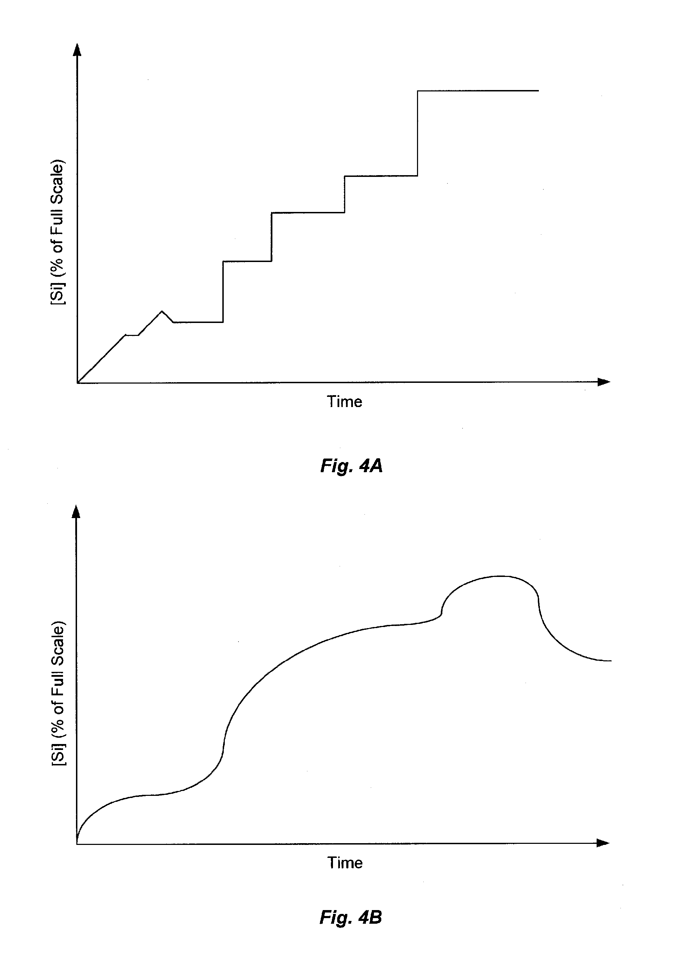

Fig. 4A is a simplified graph plotting the concentration of a silicon-containing gas component relative to a process maximum, versus time, in an embodiment of a deposition process in accordance with the present invention featuring a stepped deposition rate profile. Alternative embodiments in accordance with the present invention could exhibit a wide variety of changing, non-linear composition profiles. Fig. 4B is a simplified graph plotting the concentration of a silicon-containing gas component relative to a process maximum, versus time, for another alternative embodiment of a deposition process in accordance with the present invention featuring a nonlinear profile.

Changes in the compositions of precursors flowed during the dielectric deposition may be accomplished in a variety of ways. Embodiments of the method have an increasing relative percentage of the silicon-containing precursor to the overall precursor mixture flow. Such an increase could be produced by elevating the flow rate of the silicon-containing precursor, reducing the flow rate of the oxidizing gas precursor, reducing the flow rate of the water vapor, or any combination of a change in flow rates of the components of the processing gas mixture which results in a change in the overall percentage composition of the silicon-containing precursor.

Moreover, a change in the relative ratio of components of the precursor mixture may be accomplished by other than changing the flow rates of the components. For example, when ozone is used as the oxidizing gas precursor, it's frequently formed by flowing oxygen through an ozone generator, resulting in a gas flow comprising oxygen and some percentage of ozone. Changes in the concentration of silicon-containing precursor relative to ozone (*i.e.*, the oxidizing gas precursor) could also be accomplished by altering the conditions of generation of the ozone to increase its concentration, without altering the flow rate of the ozone into the processing chamber.

The deposition rate of the dielectric layer may also be changed by adjusting the distance between the substrate and manifold to a second distance 314. The process chamber may include an adjustable lift that can vary the space between the substrate and the manifold during the deposition. As the substrate moves closer to the manifold, it enters a zone where the precursor materials are more concentrated, and form the dielectric layer at a faster rate. Thus, when the dielectric materials can be deposited on the substrate at a higher deposition rate without causing voids or weak seams, the substrate may be moved from an initial first distance to a second distance that is closer to the process chamber manifold.

At the completion of the deposition of the dielectric layer, the precursors may stop flowing into the chamber 316. Additional process steps (*e.g.*, annealing, chemical-mechanical polishing, *etc*.) may follow the dielectric deposition, before the substrate is removed from the process chamber.

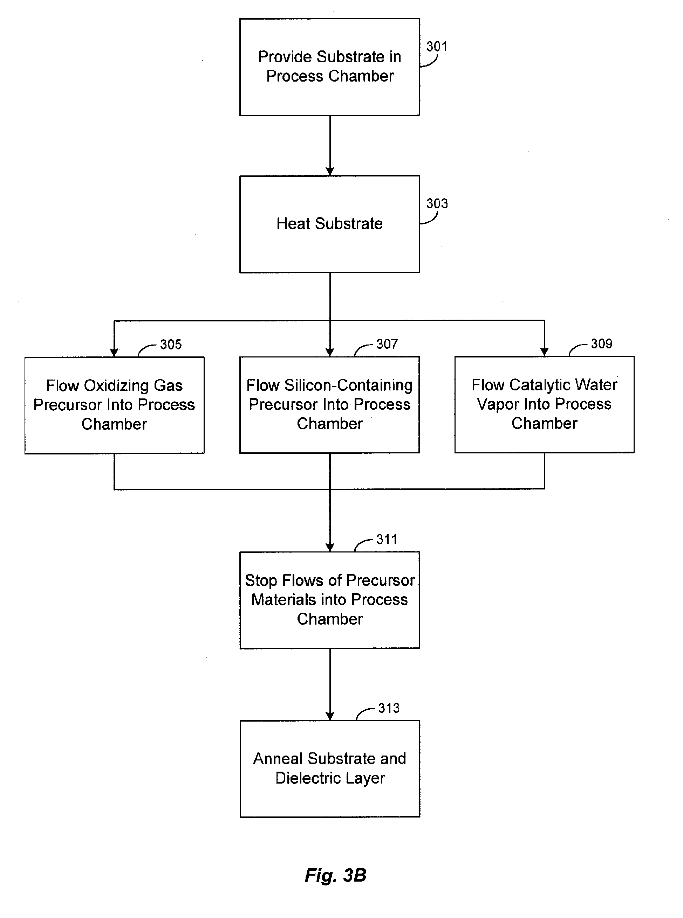

Referring now to Fig. 3B, a flowchart illustrating steps for forming a dielectric layer on a substrate according to additional embodiments of the invention is shown. The process includes providing a substrate in a process chamber in step 301. The substrate is then heated in step 303 to a temperature at which the dielectric layer is formed (*e.g.*, about 400°C or more, about 400°C to about 750°C, about 400°C to about 600°C, *etc.).* Heating the substrate facilitates the chemical vapor deposition of precursor materials into a solid, but flowable dielectric layer having a wet etch rate ratio (WERR) of about 2.5 or less. When the substrate is not heated, or heated to lower temperatures (*e.g.*, about 200°C or less), the deposited dielectric normally has a spin-on liquid consistency and may have to undergo subsequent heating and/or annealing, which may increase overall deposition time.

Precursors may be provided to the heated substrate by flowing oxidizing gas precursor, silicon-containing precursor, and water vapor precursor to the process chamber in steps 305, 306 and 307. The water vapor and other precursors may be mixed together and flow through a single channel into the process chamber at a constant flow rate until the flows are stopped at the end of the deposition 311. Alternatively, the silicon-containing precursor may flow though a channel that is independent of the oxidizing gas precursor and/or water vapor, and the flow rates of the precursors may be independently varied over the course of the deposition. The timing of the supply of the precursors may also be varied such that, for example, the oxidizing gas precursor and/or water vapor may be introduced before the silicon-containing precursor, or alternatively, all three precursors may be introduced at the same time.

The dielectric layer formed on the substrate may be annealed in step 313. The anneal may be performed in the process chamber, or the substrate may be transferred to a separate annealing chamber. Exemplary anneal processes that may be used with embodiments of the invention will now be described.

### Exemplary Post-Deposition Anneal Processes

Following the formation of the dielectric material, a post-deposition anneal may optionally be performed. The dielectric material may be annealed in an atmosphere such as N₂, N₂O, NO or NH₃. In one embodiment, the annealing process includes heating the substrate and flowing N₂O into the chamber or furnace. The N₂O interacts with the silicon oxide material at high temperatures and strengthens any remaining weak seams. The annealed layer is substantially seam-free and suited for further treatments such as CMP.

Annealing may take place *in situ* or *ex situ.* For example, the annealing may take place in the CVD chamber immediately after the deposition. Annealing alternatively may take place in another chamber of a multi-chamber system or in a different chamber system (*e.g.*, a furnace). In some embodiments, annealing comprises a Rapid Thermal Process (RTP) as more fully described in U.S. Patent No. 5,660,472.

The annealing temperature may range from about 750°C to about 1000°C for furnace anneal and up to about 1200°C for RTP anneal. The annealing duration is temperature dependent and may range from about 10 minutes to around 2 hours for furnace anneal and as few as 5 seconds up to around 3 minutes for RTP. As a result, in most cases, the layer is annealed by restructuring the SiO₂ network without exceeding the SiO₂ reflow temperature.

In other embodiments, the anneal process may include a multi-step anneal similar to those described in co-assigned U.S. Prov. Patent App. Ser. No. 60/598,939, titled "MULTI-STEP ANNEAL OF THIN FILMS FOR FILM DENSIFICATION AND IMPROVED GAP-FILL," filed August 4, 2004, by Nitin K. Ingle *et al..*

### Examples

In these examples, silicon oxide (SiO₂) dielectric materials were deposited in substrate trenches using TEOS as the silicon-containing precursor, ozone as the oxidizing gas precursor and water vapor as the hydroxyl-containing precursor. The depositions are performed in a process chamber configured for thermal CVD.

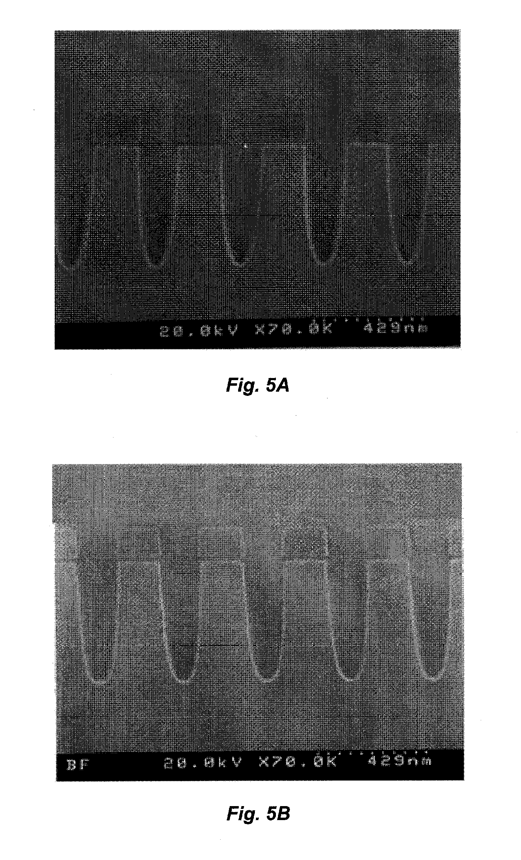

Silicon oxide gap-fills were performed according to embodiments of the methods of the invention and comparative examples using conventional gap-fill techniques were also run. Figs. 5A-B show electron micrographs of trenches filled with silicon oxide dielectric materials. The trenches had a width of about 0.15 µm and an aspect ratio (height/width) of about 6:1. Fig. 5A shows an electron micrograph of trenches filled with a silicon oxide dielectric using a conventional gap-fill technique. The conventional technique included a thermal CVD deposition at 540°C using TEOS as the silicon-containing precursor flowing at about 5000 milligrams per minute (mgm). No hydroxyl-containing precursor is introduced during the deposition. An anneal is performed following the deposition for 30 minutes at 1050°C in a nitrogen (N₂) atmosphere. The spots in the middle of the filled trenches and blurred lines around the edges of the trench in Fig. 5A show extensive formation of voids and weak seams.

In comparison, Fig. 5B shows an electron micrograph of trenches filled with a silicon oxide dielectric according to an embodiment of the methods of the present invention. During the deposition, 2500 mgm of H₂O was introduced with the TEOS. Other deposition conditions were substantially the same as for the conventional deposition described above for Fig. 5A. The micrograph in Fig. 5B lacks the spots and blurry trench edges indicative of the voids and weak seams seen in the gap-filled trenches of Fig. 5A.

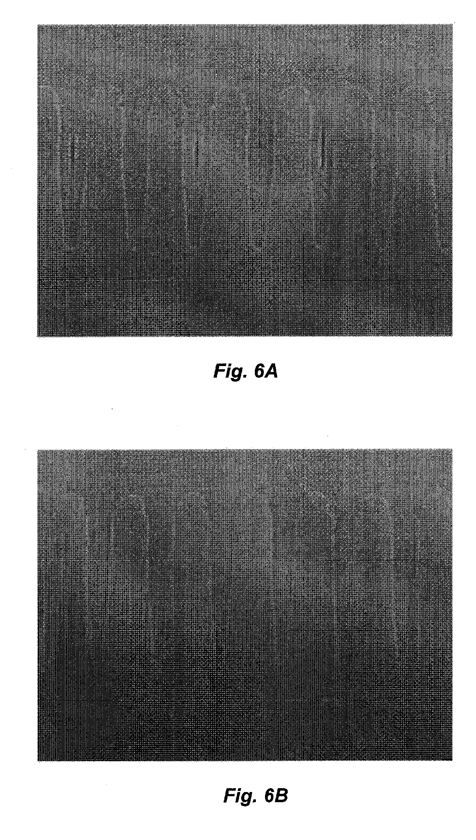

Referring now to Figs. 6A-B another pair of electron micrographs of trenches filled with silicon oxide dielectric materials are shown. Similar to Figs. 6A-B, the trenches had a width of about 0.15 µm and an aspect ratio (height/width) of about 6:1. Fig. 6A shows an electron micrograph of trenches filled with a silicon oxide dielectric using a conventional gap-fill technique. The conventional technique included a thermal CVD deposition at 540°C using TEOS as the silicon-containing precursor flowing at about 5000 milligrams per minute (mgm). The elongated spots in the middle of the filled trenches in Fig. 6A show extensive formation of voids.

In comparison, Fig. 6B shows an electron micrograph of trenches filled with a silicon oxide dielectric according to an embodiment of the methods of the present invention. During the deposition, 10 grams/minute of H₂O was introduced with the TEOS. Other deposition conditions were substantially the same as for the conventional deposition described above for Fig. 6A. The micrograph in Fig. 6B does not show any evidence of the elongated spots seen in Fig. 6A.

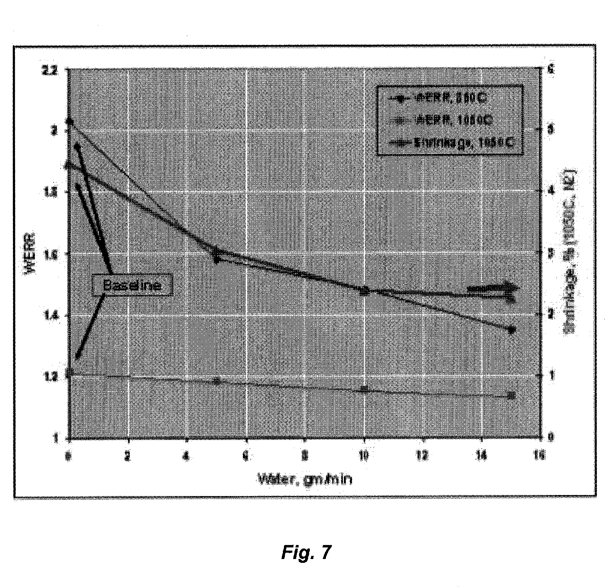

Fig. 7 shows a graph of the wet etch rate ratio (WERR) and percent shrinkage of the silicon oxide films as a function of water vapor flow rate (in grams/minute) during film deposition. The graph shows that the WERR decreases with increasing water vapor flow rate for depositions at both 850°C and 1050°C. Also, the graph shows for the 850°C deposition that there is a smaller % shrinkage following a post-deposition anneal as the water vapor flow rate increases. The drop in % shrinkage is particularly notable when going from a moisture-free deposition (*i.e.*, 0 gm/min H₂O) to a deposition that includes some water vapor *(i.e., 5* gm/min H₂O).

As noted above, the physical (e.g., phase) characteristics of the water vapor can have a significant impact of the quality of the dielectric material formed. When the water vapor supplied to the process chamber has an increasing liquid phase component (e.g., increased liquid aerosol concentration) an increased number of particle adders are observed on the surface of the deposition substrate. This correlation was demonstrated experimentally by conducting oxide depositions at a constant process chamber pressure (600 torr), temperature (540°C), silicon precursor flow rate (2700 mgm TEOS), and oxide precursor flow rate (13.5 slm O₃), but with increasingly more dilute (i.e., less concentrated) water vapor supplied.

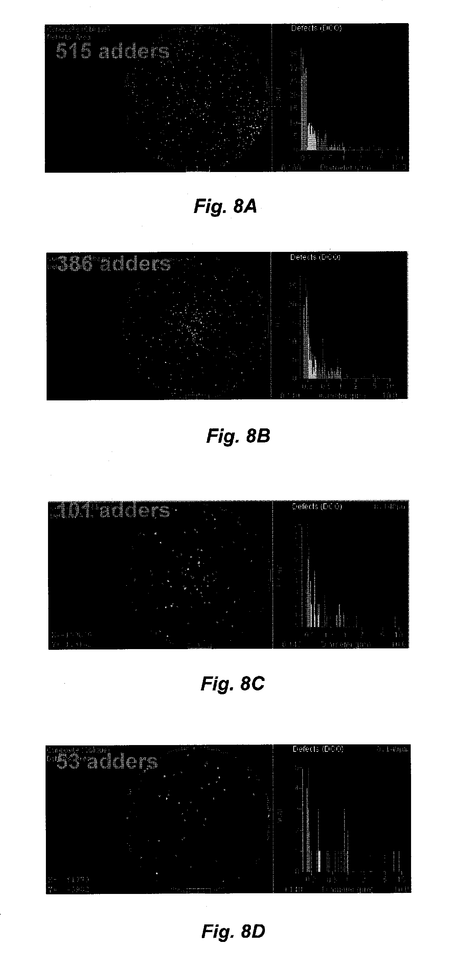

Figs. 8A-D show the number of particle adders deposited on wafer surfaces following oxide depositions with 5L of water vapor diluted in 0L, 3L, 10L, and 15L of N₂, respectively. Table 1 summarizes the particle adder results:

**Table 1: Particle Adder Count for Increasing N₂ Dilution Levels**

| Wafer No. | Water Vapor Volume (Liters) | N₂ Dilution Volume (Liters) | Particle Adder Count | Dew Point of Water Vapor (°C) |
|---|---|---|---|---|
| 1 | 5L | 0L | 515 | 94°C |
| 2 | 5L | 5L | 386 | 67°C |
| 3 | 5L | 10L | 101 | 60°C |
| 4 | 5L | 15L | 53 | 56°C |

The data unmistakably show a decreasing number of deposited particle adders being deposited on the wafer surface with increasing N₂ dilution of the water vapor supplied to the process chamber. The righthand most column of Table 1 also shows how the particle adder count correlates to the dew point of the water vapor in the process chamber. The dew point of a constant volume gas mixture is the temperature to which the volume must be cooled, at constant pressure, for the gaseous water vapor to start condensing into a liquid phase (i.e., dew). As Table 1 shows, the lower the dew point of the water vapor in the process chamber, the fewer the number of particle adders formed.

The correlation of the decreasing dew point of the water vapor in the chamber with the decreasing number of particle adders suggests that the liquid phase water component of the water vapor in the chamber plays a significant role in particle adder formation. While not wishing to be bound by a particular theory, it is believed that liquid aerosol droplets of water provide a nucleus for the reaction of silicon species that ultimately develop into the particle adders. Thus, the more aerosol particles present in the process chamber, the more particle that will be deposited on the wafer substrate.

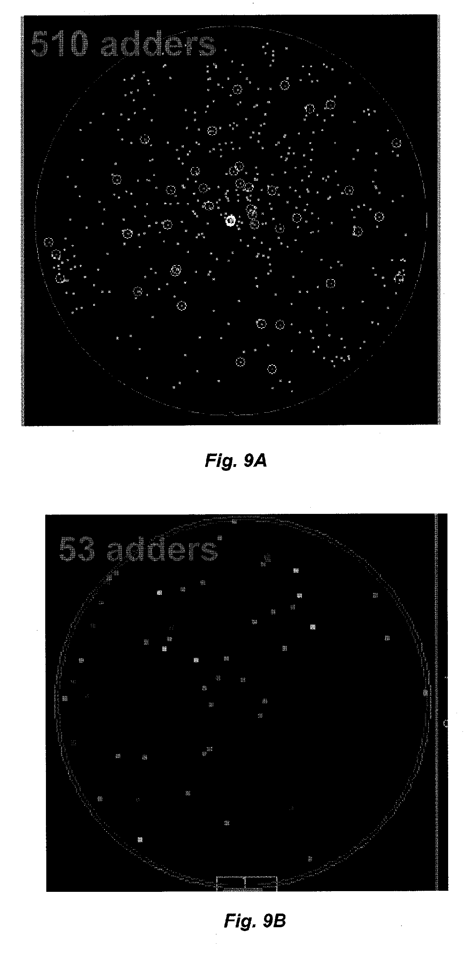

Another set of experiments demonstrates that method of generating the water vapor can have a dramatic impact on the number of particle adders deposited on a wafer surface. Figs. 9A&B show the number of particle adders deposited on the surface of a substrate wafer using different water vapor generation methods. Both depositions were a silicon oxide deposition at a constant process chamber pressure (600 torr), temperature (540°C), silicon precursor flow rate (2700 mgm TEOS), oxide precursor flow rate (13.5 slm O₃), and volume of supplied water vapor (5L). The difference between depositions was that the wafer surface outlined in Fig. 9A used a conventional liquid vaporizer (direct liquid injection) method to generate water vapor by evaporating a liquid water source and mixing the water vapor with a carrier gas, while the wafer surface in Fig. 9B used a catalytic water vapor generation method.

Fig. 9A shows 510 particle adders were deposited on the wafer substrate when a direct liquid injection method was used evaporate a liquid water source and generate water vapor during for a silicon oxide dielectric deposition. In contrast, Fig. 9B shows nearly an order of magnitude fewer particle adders deposited on the surface (53 adders) when the process used a catalytic water vapor generation method to generate and supply the water vapor to the process chamber. The difference in the number of particle adders clearly shows that the choice of method to generate and supply water vapor has a significant impact on the number of particle adders deposited on the wafer. Consequently, the choice of water vapor generation method can have a significant impact on the commercial viability of silicon oxide deposition systems and methods that incorporate water vapor as a deposition precursor.

### Exemplary Semiconductor Structure

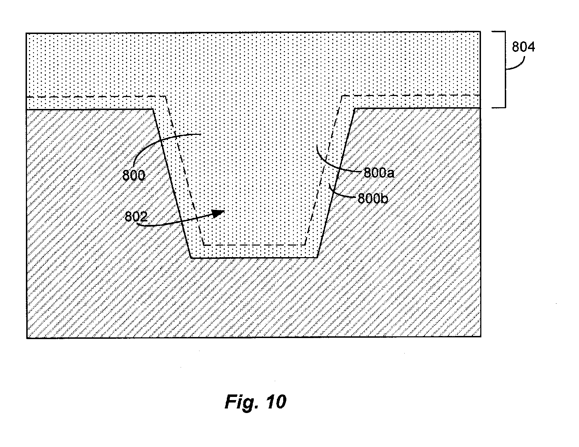

Fig. 10 shows a simplified cross-sectional view of an oxide-filled trench structure formed utilizing an embodiment of a process in accordance with the present invention. Specifically, the time-varied flow rate ratio of silicon-containing precursor: oxidizing gas precursor during the deposition process results in formation of an oxide film 800 that includes a highly conformal portion 800a proximate to the surrounding silicon sidewalls, but which also includes a less-conformal body portion 800b which fills the entire volume of the trench 802 and creates overlying bulk layer 804 in a reasonable period of time. The oxide-filled trench 802 of Fig. 10 does not include the voids or weak seams associated with similar features formed utilizing the conventional oxide CVD processes previously described.

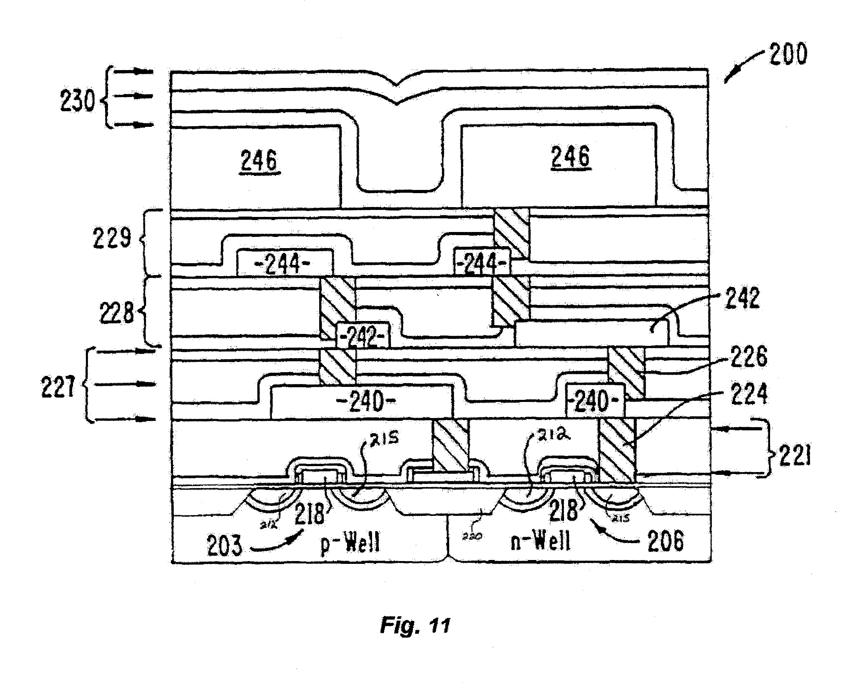

Trenches like the ones shown in Fig. 10 may be used in shallow trench isolation structures like those shown in Fig. 11, which illustrates simplified cross-section of an integrated circuit 200 according to embodiments of the invention. As shown in Fig. 11, the integrated circuit 200 includes NMOS and PMOS transistors 203 and 206, which are separated and electrically isolated from each other by oxide-filled trench isolation structure 220. Alternatively, field oxide isolation can be used to isolate devices, or a combination of isolation techniques may be used. Each of the transistors 203 and 206 comprises a source region 212, a gate region 215, and a drain region 218.

A premetal dielectric (PMD) layer 221 separates the transistors 203 and 206 from the metal layer 240, with connections between metal layer 240 and the transistors made by contacts 224. The premetal dielectric layer 221 may comprise a single layer or multiple layers. The metal layer 240 is one of four metal layers, 240, 242, 244, and 246, included in the integrated circuit 200. Each metal layer is separated from adjacent metal layers by intermetal dielectric layers 227, 228, and 229. Adjacent metal layers are connected at selected openings by vias 226. Planarized passivation layers 230 are deposited over the metal layer 246.

A silicon oxide layer according to the present invention may be used to form one or more of the dielectric layers shown in integrated circuit 200. For example, a silicon oxide layer deposited according to the present invention may be used to create trench isolation structure 220. A silicon oxide layer deposited according to the present invention may also be used to create PMD layer 221, or the higher layer intermetal dielectric layers 227-229 of the overlying interconnect structure.

A silicon oxide layer according to the present invention may also be used in damascene layers, which are included in some integrated circuits. In damascene layers, a blanket layer is deposited over a substrate, selectively etched through to the substrate, and then filled with metal and etched back or polished to form metal contacts 224. After the metal layer is deposited, a second blanket deposition is performed and selectively etched. The etched areas are then filled with metal and etched back or polished to form vias 226.

It should be understood that the simplified integrated circuit 200 is for illustrative purposes only. One of ordinary skill in the art could implement the present method for fabrication of other integrated circuits, such as microprocessors, application-specific integrated circuits (ASICs), memory devices, and the like.

### Exemplary Deposition System

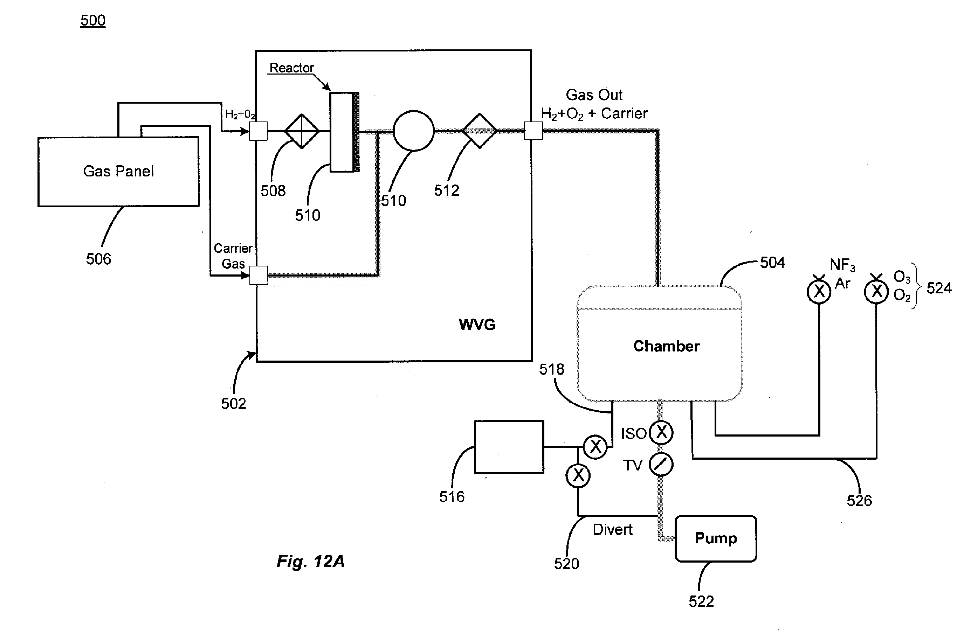

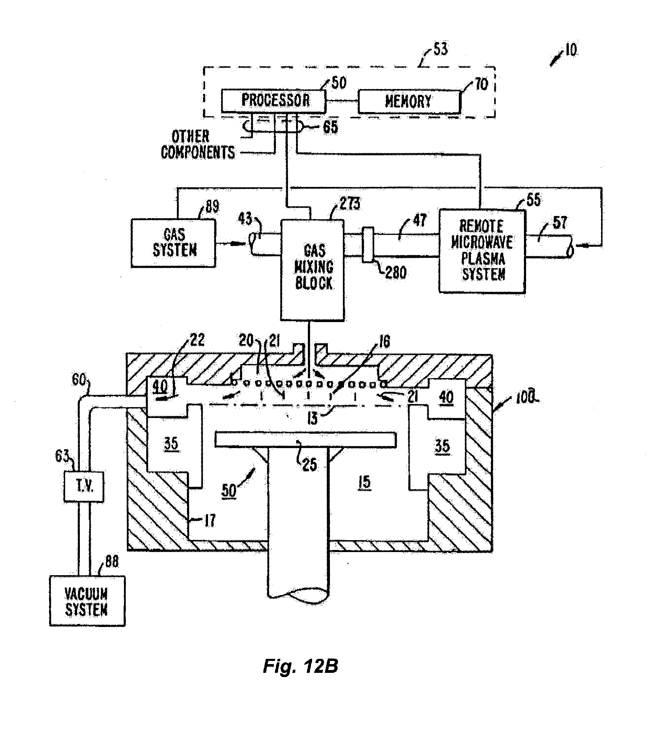

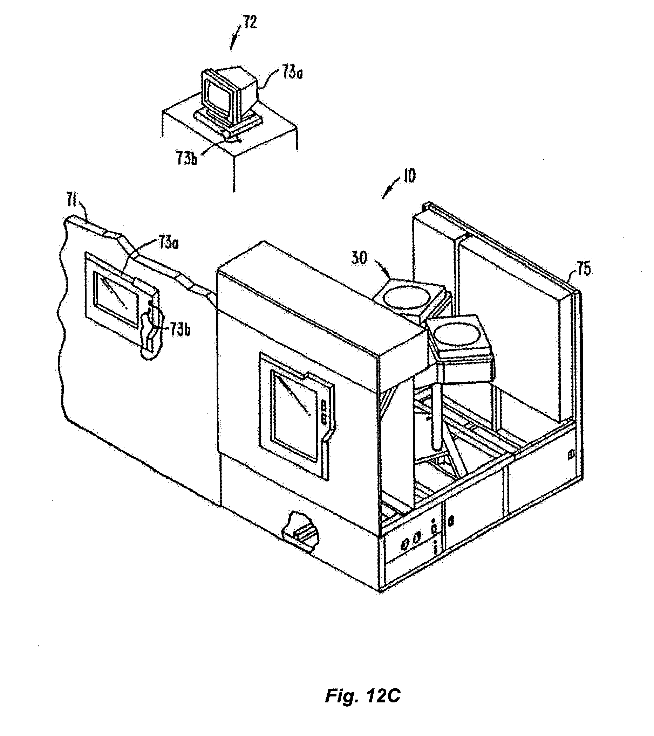

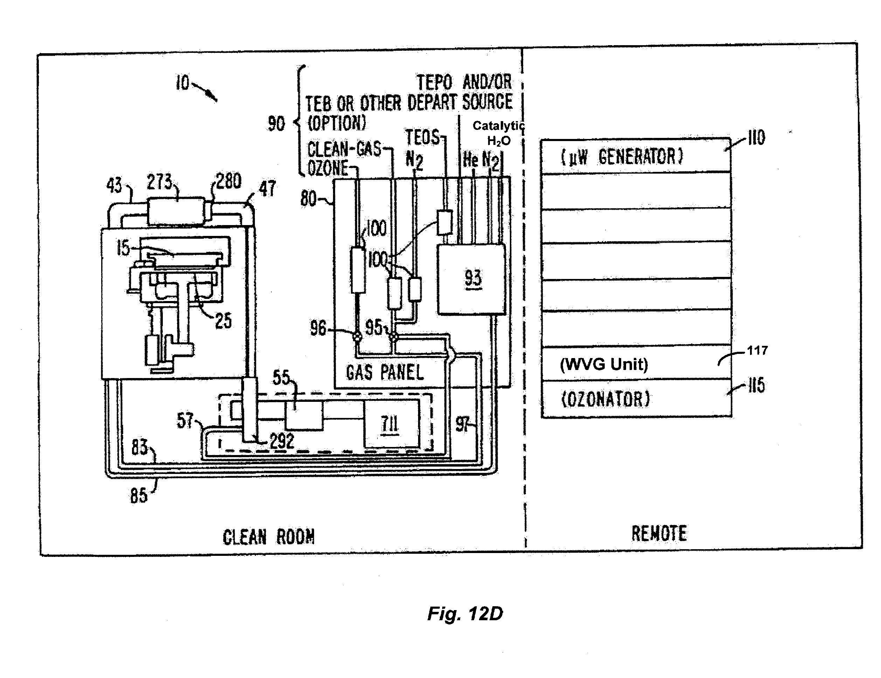

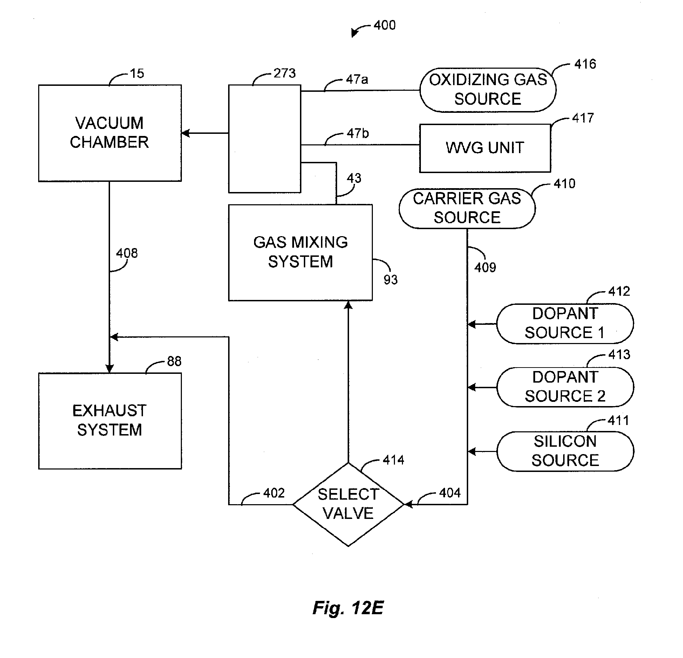

Fig 12A shows a simplified diagram of a system 500 for depositing a dielectric layer according to embodiments of the invention. This system 500 includes a catalytic water vapor generation unit 502 that supplies gas phase water vapor to the process chamber 504 during a dielectric layer deposition. The WVG unit 502 includes a gas panel 506 that stores and supplies hydrogen gas (H₂) and oxygen gas (O₂) that is catalytically converted into the water vapor. The gas panel 506 may also store and deliver carriers gases *(e.g.,* H₂, He, *etc.)* to the WVG unit 502. In the embodiment shown, the gases from gas panel 506 are supplied by two separate lines to the WVG unit 502. A first line supplies a mixture of hydrogen and oxygen gas to the unit, and a second line supplies carrier gas (*e.g.*, N₂) to the unit. Embodiments may also include mixing oxygen gas and/or hydrogen gas with the carrier gas in the second line (*e.g.*, a N₂ and O₂ gas mixture).

The hydrogen and oxygen gas mixture may be run through a particle filter 508 to remove particulates in the gas stream. The gas mixture may then be introduced to the catalytic reactor 510 that includes materials to catalytically convert the hydrogen and oxygen into water vapor. In the embodiment shown in Fig. 10A, the reactor catalyst 510 includes platinum as the catalyst material. The catalytic reactor 510 is heated to a temperature (*e.g.*, about 100°C to about 400°C, about 350°C, *etc.)* where the molecular hydrogen and oxygen catalytically dissociate and recombine into gaseous water vapor.

The catalytically generated water vapor from the catalytic reactor 510 may be combined with carrier gas (*i.e.*, dilution gas), such as N₂ supplied in a separate gas line to the WVG unit 502. In alternative embodiments (not shown) a carrier gas may be premixed with the molecular hydrogen and oxygen gas and supplied as a single mixture to the catalytic reactor 510. In another alternative embodiment (not shown) some carrier gas may be supplied with the hydrogen and oxygen gas to the catalytic reactor, while additional (and/or another carrier gas) may be added to the catalytically generated water vapor from the reactor.

The temperature and/or relative amounts of catalytic water vapor and carrier gas may be monitored by a sensor 512 measuring concentration of the water vapor in the mixture. The sensor 512 may also measure concentration of one or more other components of the mixture (e.g., the carrier gas concentration). Water vapor concentration data measured by the sensor 512 may be used to regulate the flow of the water vapor and/or carrier gas to maintain the water vapor exiting the WVG unit 502 at a preset level.

The temperature data may be used to regulate the temperature of the water vapor exiting the unit 502. In the embodiment shown in Fig. 10A, the water vapor forming in the catalytic reactor 510 may have approximately the same temperature as the rest of the reactor (*e.g.*, about 350°C). The water vapor emitted from reactor 510 may then be combined with a carrier gas at a lower temperature (*e.g.*, about 140°C), which may decrease the temperature of the water vapor to approximately the same level. The water vapor/carrier gas mixture may be filtered to remove particles with filter 514, before leaving the WVG unit 502 for the processing chamber 504. If oxygen and/or hydrogen gas are included in the stream of carrier gas mixed with the catalytically generated water vapor, then the water vapor mixture supplied to the processing chamber 504 may also include these precursors (*e.g.*, a water vapor, nitrogen gas (N₂) and oxygen gas (O₂) mixture).

The water vapor precursor generated by WVG unit 502 may be supplied directly to the processing chamber 504 as shown in Fig. 10A. Additional fluid lines may supply other precursors to the chamber 504. For example, the silicon precursor 516 may be supplied by another line 518 to the chamber, and may be diluted in a carrier gas (*e.g.*, N₂, He). In the embodiment shown, the silicon precursor line 518 may also be coupled to a divert line 520 that is also coupled to a vacuum pump 522 for evacuating the processing chamber 504 and one or more gas lines (e.g., silicon precursor line 518).

A supply of oxygen precursor 524 (*e.g.,* O₂, O₃, N₂O, *etc.)* may also be supplied to the processing chamber 504 through an oxygen supply line 526. In addition, supplies of other gases, such as argon for HDP dielectric depositions, *etc*., and fluorine precursors (*e.g.*, NF₃, fluorocarbons, *etc.)* for fluorine doping and chamber clean process may also be coupled to the processing chamber.

The catalytically generated water vapor and other precursors are supplied to the process chamber 504, where a dielectric film is deposited on a substrate. Embodiments of the invention include a variety of dielectric layer deposition processes and systems, including thermal, and/or plasma chemical vapor-deposition techniques. Plasma depositions may include processes and process chambers equipped for high-density plasma CVD, plasma-enhanced CVD, and/or remotely generated plasmas used with CVD to form the dielectric layer.

Fig. 10B shows a simplified diagram of a system 10 according to embodiments of the invention with additional details about the processing chamber and other system components that may be used for chemical vapor deposition ("CVD"). This system 10 may be configured for performing thermal, plasma, and sub-atmospheric CVD ("SACVD") processes, as well as other processes, such as reflow, drive-in, cleaning, etching, and gettering processes. Multiple-step processes can also be performed on a single substrate or wafer without removing the substrate from the chamber. The major components of the system include, among others, a vacuum chamber 15 that receives process and other gases from a gas delivery system 89, a vacuum system 88, a remote microwave plasma system 55, and a control system 53. These and other components are described below in order to understand the present invention.

The CVD apparatus 10 includes an enclosure assembly 102 housing a vacuum chamber 15 with a gas reaction area 16. A gas distribution plate 20 is provided above the gas reaction area 16 for dispersing reactive gases and other gases, such as purge gases, through perforated holes in the gas distribution plate 20 to a wafer (not shown) that rests on a vertically movable heater 25 (also referred to as a wafer support pedestal). The heater 25 can be controllably moved between a lower position, where a wafer can be loaded or unloaded, for example, and a processing position closely adjacent to the gas distribution plate 20, indicated by a dashed line 13, or to other positions for other purposes, such as for an etch or cleaning process. A center board (not shown) includes sensors for providing information on the position of the wafer.

The heater 25 includes an electrically resistive heating element (not shown) enclosed in a ceramic. The ceramic protects the heating element from potentially corrosive chamber environments and allows the heater to attain temperatures up to about 800°C. In an exemplary embodiment, all surfaces of the heater 25 exposed to the vacuum chamber 15 are made of a ceramic material, such as aluminum oxide (Al₂O₃ or alumina) or aluminum nitride.

Deposition precursors and carrier gases may be supplied from gas delivery system 89, through the supply line 43, and into a gas mixing box (also called a gas mixing block) 273, where they are preferably mixed together and delivered to the gas distribution plate 20. For example, silicon-containing precursor, such as silane, dimethylsilane, trimethylsilane, tetramethylsilane, diethylsilane, tetramethylorthosilicate (TMOS), tetraethylorthosilicate (TEOS), octamethyltetrasiloxane (OMTS), octamethylcyclotetrasiloxane (OMCTS), tetramethylcyclotetrasiloxane (TOMCATS), or mixtures thereof may be supplied to supply line 43 along with an oxide gas, such as oxygen (O₂), ozone (O₃), NO, NO₂, or mixtures thereof, and the water vapor.

The gas delivery system 89 may include a catalytic water vapor generation unit (not shown) to supply the water vapor though supply line 43. As shown in Fig. 10A above, the WVG unit may include inlet lines for hydrogen and oxygen gas, and may also include an inlet for carrier gas *(e.g.,* N2, He, mixtures thereof, *etc.).* The output of the WVG unit is catalytically generated water vapor having little or no liquid phase component (*e.g.*, aerosol droplets) that may be diluted in a carrier gas and supplied to the supply line 43 and gas mixing block 273.

The gas mixing box 273 is preferably a dual input mixing block coupled to a process gas supply line 43 and to a cleaning/etch gas conduit 47. A valve 280 operates to admit or seal gas or plasma from the gas conduit 47 to the gas mixing block 273. The gas conduit 47 receives gases from an integral remote microwave plasma system 55, which has an inlet 57 for receiving input gases. During deposition processing, gas supplied to the plate 20 is vented toward the wafer surface (as indicated by arrows 21), where it may be uniformly distributed radially across the wafer surface, typically in a laminar flow.

Purging gas may be delivered into the vacuum chamber 15 from the plate 20 and/or an inlet port or tube (not shown) through the bottom wall of enclosure assembly 102. The purging gas flows upward from the inlet port past the heater 25 and to an annular pumping channel 40. An exhaust system then exhausts the gas (as indicated by arrows 22) into the annular pumping channel 40 and through an exhaust line 60 to a vacuum system 88, which includes a vacuum pump (not shown). Exhaust gases and entrained particles are drawn from the annular pumping channel 40 through the exhaust line 60 at a rate controlled by a throttle valve system 63.

In other embodiments (not shown) the silicon-containing precursors and the hydroxyl-containing precursors may travel through separate supply lines to a gas distribution plate in order to prevent them from reacting prematurely before reaching the substrate. As example of the dual channel supply line and showerhead design is described in co-assigned U.S. Patent No. 6,624,091, titled "METHODS OF FORMING GAP FILL AND LAYERS FORMED THEREBY," filed May 7, 2001.

The remote microwave plasma system 55 can produce a plasma for selected applications, such as chamber cleaning or etching native oxide or residue from a process wafer. Plasma species produced in the remote plasma system 55 from precursors supplied via the input line 57 are sent via the conduit 47 for dispersion through the plate 20 to the vacuum chamber 15. Precursor gases for a cleaning application may include fluorine, chlorine, and other reactive elements. The remote microwave plasma system 55 also may be adapted to deposit plasma-enhanced CVD films by selecting appropriate deposition precursor gases for use in the remote microwave plasma system 55.

The system controller 53 controls activities and operating parameters of the deposition system. The processor 50 executes system control software, such as a computer program stored in a memory 70 coupled to the processor 50. Preferably, the memory 70 may be a hard disk drive, but of course the memory 70 may be other kinds of memory, such as read-only memory or flash memory. In addition to a hard disk drive (*e.g.*, memory 70), the CVD apparatus 10 in a preferred embodiment includes a floppy disk drive and a card rack (not shown).

The processor 50 operates according to system control software, which includes sets of instructions that dictate the timing, mixture of gases, chamber pressure, chamber temperature, microwave power levels, susceptor position, and other parameters of a particular process. Other computer programs such as those stored on other memory including, for example, a floppy disk or another computer program product inserted in a disk drive or other appropriate drive, may also be used to operate the processor 50 to configure the CVD system 10 into various apparatus.

The processor 50 has a card rack (not shown) that contains a single-board computer, analog and digital input/output boards, interface boards and stepper motor controller boards. Various parts of the CVD system 10 conform to the Versa Modular European (VME) standard which defines board, card cage, and connector dimensions and types. The VME standard also defines the bus structure having a 16-bit data bus and 24-bit address bus.

Fig. 10C is a simplified diagram of a user interface in relation to the CVD apparatus chamber 30. The CVD apparatus 10 includes one chamber of a multichamber system. Wafers may be transferred from one chamber to another for additional processing. In some cases the wafers are transferred under vacuum or a selected gas. The interface between a user and the processor is via a CRT monitor 73a and a light pen 73b. A mainframe unit 75 provides electrical, plumbing, and other support functions for the CVD apparatus 10. Exemplary mainframe units compatible with the illustrative embodiment of the CVD apparatus are currently commercially available as the PRECISION 5000™, the CENTURA 5200™, and the PRODUCER SE™ systems from APPLIED MATERIALS, INC. of Santa Clara, California.

In the preferred embodiment two monitors 73a are used, one mounted in the clean room wall 71 for the operators, and the other behind the wall 72 for the service technicians. Both monitors 73a simultaneously display the same information, but only one light pen 73b is enabled. The light pen 73b detects light emitted by the CRT display with a light sensor in the tip of the pen. To select a particular screen or function, the operator touches a designated area of the display screen and pushes the button on the pen 73b. The touched area changes its highlighted color, or a new menu or screen is displayed, confirming communication between the light pen and the display screen. Of course, other devices, such as a keyboard, mouse, or other pointing or communication device, may be used instead of or in addition to the light pen 73b to allow the user to communicate with the processor.

Fig. 10D illustrates a general overview of an embodiment of a gas supply panel 80 that may supply precursors to the CVD apparatus 10 at another location (*e.g.*, a clean room). As discussed above, the CVD system 10 includes a chamber 15 with a heater 25, a gas mixing box 273 with inputs from an inlet tube 43 and a conduit 47, and remote microwave plasma system 55 with input line 57. As mentioned above, the gas mixing box 273 is for mixing and injecting deposition gas(es) and clean gas(es) or other gas(es) through the inlet tube 43 to the processing chamber 15.

The remote microwave plasma system 55 is integrally located and mounted below the chamber 15 with the conduit 47 coming up alongside the chamber 15 to the gate valve 280 and the gas mixing box 273, located above the chamber 15. Microwave generator 110, ozonator 115, and catalytic water vapor generation unit 117 may be located remote from the process chamber in the clean room. Supply lines 83 and 85 from the gas supply panel 80 provide precursors (*e.g.*, reactive gases) to the gas supply line 43. The gas supply panel 80 includes lines from gas or liquid sources 90 that provide the precursors for a selected application. The gas supply panel 80 has a mixing system 93 that mixes selected gases before flow to the gas mixing box 273. In some embodiments, gas mixing system 93 includes a liquid injection system for vaporizing reactant liquids including silicon-containing precursors such as tetrammethylorthosilicate ("TMOS"), tetraethylorthosilicate ("TEOS"), octamethyltetrasiloxane (OMTS), octamethylcyclotetrasiloxane (OMCTS), tetramethylcyclotetrasiloxane (TOMCATS), catalytically generated water vapor that may be diluted in a carrier gas, and hydrogen peroxide, and dopants such as triethylborate ("TEB"), triethylphosphate ("TEPO") and diborane (B₂H₆). Vapor from the liquids is usually combined with a carrier gas, such as helium. Supply lines for the process gases may include (i) shut-off valves 95 that can be used to automatically or manually shut off the flow of process gas into line 85 or line 57, and (ii) liquid flow meters (LFM) 100 or other types of controllers that measure the flow of gas or liquid through the supply lines.

As an example, a mixture including TEOS as a silicon source may be used with gas mixing system 93 in a deposition process for forming a silicon oxide film. The TEPO is a liquid source that may be vaporized by conventional boiler-type or bubbler-type hot boxes. However, a liquid injection system is preferred as it provides greater control of the volume of reactant liquid introduced into the gas mixing system. The liquid is typically injected as a fine spray or mist into the carrier gas flow before being delivered to a heated gas delivery line 85 to the gas mixing block and chamber. One or more sources, such as oxygen (O₂), ozone (O₃), NO or NO₂ flow to the chamber through another gas delivery line 83, to be combined with the reactant gases from heated gas delivery line 85 near or in the chamber. Of course, it is recognized that other sources of dopants, silicon, and oxygen also may be used.

Fig. 10E is a simplified schematic diagram of a CVD deposition apparatus for depositing oxide layers in accordance with embodiments of the present invention. While the apparatus may be used to deposit silicon oxide films, it may also beneficially be applied to single-or multiple-layer doped silicon glass films, such as borophosphosilicate glass ("BPSG"), phosphosilicate glass ("PSG"), borosilicate glass ("BSG"), arsenic-silicon glass ("AsSG"), or similar films.

CVD deposition apparatus 400 comprises oxidizing gas source 416 and a catalytic water vapor generation unit for supplying the catalytically generated water vapor 417 in fluid communication with vacuum chamber 15 through gas mixing box 273. The oxidizing gas source 416 may contain oxygen (O₂), ozone (O₃), NO, NO₂, and mixtures of these gases, among other oxidizing gases. The catalytic water vapor generation unit may be coupled to sources of hydrogen and oxygen gas that are catalytically converted into the water vapor, as well as carrier gas *(e.g.,* N2, He, mixtures thereof, *etc.)* to dilute, cool, and/or transport the H₂, O₂ and catalytically generated water vapor to and from the unit 417.

Carrier gas source 410, silicon-containing gas source 411, first dopant gas (*e.g.*, TEPO) source 412, and second dopant gas (*e.g.*, TEB) source 413 are in fluid communication with vacuum chamber 15 through select valve 414 gas mixing system 93, and gas mixing box 273. Select valve 414 is selectively operable to shunt silicon- and dopant-containing gases such as TEOS vapor through divert line 402 to foreline 408 of chamber exhaust system 88, thereby circumventing vacuum chamber 15 entirely. Select valve 414 and divert line 402 allow the flow of silicon-containing gas to stabilize prior to its being routed to the vacuum chamber to commence an oxide CVD step in accordance with an embodiment of the present invention.

As noted above, the systems and methods of the invention may also be implemented on plasma based chemical vapor deposition systems. For example, the present invention may be used with plasma systems like the one described in commonly assigned U.S. Patent No. 6,734,155, titled "PLASMA PROCESSES FOR DEPOSITING LOW DIELECTRIC CONSTANT FILMS," filed August 27, 2002, and HDP-CVD systems like the one described in commonly-assigned U.S. Patent No. 6,740,601, titled "HDP-CVD DEPOSITION PROCESSES FOR FILLING HIGH ASPECT RATIO GAPS," filed May 11, 2001.

While the above is a complete description of specific embodiments of the present invention, various modifications, variations, and alternatives may be employed. Alternative embodiments of process recipes in accordance with the present invention could call for flowing the silicon-containing component of the process gas flow at a sufficiently high initial concentration to allow the process gases to be introduced directly into the chamber, without an initial flow diversion phase.

Moreover, other techniques for varying the parameters of deposition of an oxide layer could be employed in conjunction with the variation in concentration of the process gas flow components described so far. Examples of other possible parameters to be varied include but are not limited to the temperature of deposition, the pressure of deposition, and the flow rate of processing gases containing dopants such as arsenic (As), boron (B), and phosphorous (P).

Where a range of values is provided, it is understood that each intervening value, to the tenth of the unit of the lower limit unless the context clearly dictates otherwise, between the upper and lower limits of that range is also specifically disclosed. Each smaller range between any stated value or intervening value in a stated range and any other stated or intervening value in that stated range is encompassed within the invention. The upper and lower limits of these smaller ranges may independently be included or excluded in the range, and each range where either, neither or both limits are included in the smaller ranges is also encompassed within the invention, subject to any specifically excluded limit in the stated range. Where the stated range includes one or both of the limits, ranges excluding either or both of those included limits are also included in the invention.

As used herein and in the appended claims, the singular forms "a", "and", and "the" include plural referents unless the context clearly dictates otherwise. Thus, for example, reference to "a process" includes a plurality of such processes and reference to "the precursor" includes reference to one or more precursors and equivalents thereof known to those skilled in the art, and so forth.

Also, the words "comprise," "comprising," "include," "including," and "includes" when used in this specification and in the following claims are intended to specify the presence of stated features, integers, components, or steps, but they do not preclude the presence or addition of one or more other features, integers, components, steps, or groups.

## Claims

1. A chemical vapor deposition method for forming a dielectric material on a substrate, the method comprising:
generating water vapor by contacting hydrogen gas and oxygen gas with a water vapor generation catalyst, and providing the water vapor to a process chamber;
flowing a silicon-containing precursor into the process chamber housing the substrate;
flowing an oxidizing gas into the chamber; and
causing a reaction between the silicon-containing precursor, the oxidizing gas and the water vapor to form the dielectric material on the substrate; and
varying over time a ratio of the silicon-containing precursor to the oxidizing gas flowed into the chamber to alter a rate of deposition of the dielectric material.

2. The chemical vapor deposition method of claim 1, wherein the water vapor generation catalyst comprises platinum.

3. The chemical vapor deposition method of claim 1 or 2, wherein the method comprises diluting the water vapor with a carrier gas before providing the water vapor to the process chamber.

4. The chemical vapor deposition method of claim 3, wherein the water vapor is diluted in a carrier gas to a concentration of less than about 333.3050999 hPa (250 torr) partial pressure before being provided to the process chamber and/or the water vapor is provided in a carrier gas to the process chamber at a flow rate of about 5000 to 15000 sccm and/or the carrier gas comprises an inert gas and/or nitrogen gas.

5. The chemical vapor deposition method of any of the preceding claims, wherein the method comprises adjusting a temperature of the hydrogen gas and oxygen gas to a range of about 50°C to about 500°C.

6. The chemical vapor deposition method of any of the preceding claims, wherein the method comprises adjusting a temperature of the water vapor to a range of about 100°C to about 200°C.

7. The chemical vapor deposition method of any of the preceding claims, wherein the method comprises increasing over time a ratio of the silicon-containing precursor to the water vapor flowing into the chamber or increasing over time a ratio of the silicon-containing precursor to the oxidizing gas flowed into the chamber to alter a rate of deposition of the dielectric material.

8. The chemical vapor deposition method of any of the preceding claims, wherein the method further comprises providing hydrogen peroxide to the process chamber.

9. The chemical vapor deposition method of any of the preceding claims, wherein the silicon-containing precursor comprises silane, dimethylsilane, trimethylsilane, tetramethylsilane, diethylsilane, tetramethylorthosilicate (TMOS), tetraethylorthosilicate (TEOS), octamethyltetrasiloxane (OMTS), octamethylcyclotetrasiloxane (OMCTS), tetramethylcyclotetrasiloxane (TOMCATS), or mixtures thereof, and/or the oxidizing gas comprises O₂, O₃, NO, NO₂ or mixtures thereof.

10. The chemical vapor deposition method of any of the preceding claims, wherein the method comprises flowing a dopant precursor into the chamber.

11. The chemical vapor deposition method according to any of the preceding claims, the method further comprising:
forming a first dielectric layer on the substrate;
and
discontinuing the flow of the water vapor into the chamber and forming a second dielectric layer on the first dielectric layer, wherein the second dielectric layer is formed without the water vapor

12. A substrate processing apparatus (500) comprising:
a substrate support (25) configured to support a substrate within a processing chamber (504);
a gas delivery system (89) configured to receive a silicon-containing precursor, an oxidizing processing gas, and water vapor and deliver them to the processing chamber (504);
a water vapor generator (502) that provides the water vapor to the gas delivery system, wherein the generator comprises a catalyst that produces the water vapor by from a mixture of hydrogen gas and oxygen gas; and
a controller (53) configured to control the gas delivery system (89) and the substrate support (25), wherein the controller (53) is adapted to introduce the silicon-containing precursor, the water vapor and the oxidizing processing gas into the processor chamber (504) to form a dielectric layer on the substrate, and is adapted to alter the position of the substrate support relative to the gas delivery system during the deposition of the dielectric layer.

13. The substrate processing apparatus of claim 12, wherein the controller (53) is adapted to vary the concentration of the silicon-containing precursor to the oxidizing processing gas over time during the deposition of the dielectric layer on the substrate, as the silicon-containing precursor gas is continuously flowed into the chamber.

14. The substrate processing apparatus of claim 12 or 13, wherein the controller (53) is adapted to move the substrate support closer to the gas delivery system during the deposition of the dielectric layer to increase a deposition rate for the dielectric layer.

15. The substrate processing apparatus of any of claims 12 to 14, wherein the catalyst comprises platinum.
